# EUROPÄISCHE PATENTSCHRIFT

(11) **EP 3 762 318 B1**
(45) Veröffentlichungstag und Bekanntmachung des Hinweises auf die Patenterteilung: **02.08.2023**
(21) Anmeldenummer: 19708037.7
(22) Anmeldetag: 21.02.2019
(51) Int. Cl.: B65G 21/20, B65G 47/22

(54) **EINRICHTUNG ZUM ZENTRIEREN VON ELEKTRISCHE BAUELEMENTE AUFNEHMENDEN GURTSPULEN**
DEVICE FOR CENTRING BELT REELS ACCOMMODATING AN ELECTRICAL COMPONENT
DISPOSITIF POUR LE CENTRAGE DE BOBINES DE CEINTURE LOGEANT DES COMPOSANTS ÉLECTRIQUES

(30) Priorität: 05.03.2018 DE 102018104974
(43) Veröffentlichungstag der Anmeldung: 13.01.2021
(73) Patentinhaber: Otto Künnecke GmbH, 37603 Holzminden (DE)
(72) Erfinder: PHILIPP, Jürgen, 79639 Grenzach-Wyhlen (DE)
(74) Vertreter: Müller Hoffmann & Partner
(86) Internationale Anmeldenummer: PCT/EP2019/054306
(87) Internationale Veröffentlichungsnummer: WO 2019/170427

(56) Entgegenhaltungen:
- EP-A1- 0 480 066
- EP-A2- 0 051 105
- CN-B- 105 059 805

## Beschreibung

Einrichtung zum Zentrieren von elektrische Bauelemente aufnehmenden Gurtspulen Die Erfindung betrifft eine Einrichtung, gemäß dem Oberbegriff des Patentanspruchs 1, zum Zentrieren von elektrische Bauelemente aufnehmenden Gurtspulen für eine Anlage zum Lagern, Ein- und Ausgeben der Gurtspulen, wobei die Gurtspule mit einer flachen Außenseite auf eine flache waagerechte Auflage der Einrichtung in einem Eingabebereich der Auflage auflegbar ist.

Die DE102013006524 A1 offenbart eine Einrichtung in der die Gurtspule durch einen Greifer auf eine waagerechte Zwischenablage aufgelegt und in dieser Position durch eine stationäre weitwinkelige optische Sensoreinrichtung auf Größe und Identität überprüft wird. Eine genaue Lagebestimmung der Gurtspule erscheint aufgrund der schrägen Abtastung der unterschiedlich dicken, unebenen Gurtspulen nicht möglich.

Ferner ist durch die EP2745996 B1 eine Messstation für Gurtspulen bekannt geworden, bei der die jeweilige Gurtspule auf einem flachen Schieber gehalten ist, der die Gurtspule zwischen mehreren Lichtschranken der Station verschiebt und damit und so Außenabmessungen der Gurtspule erfasst. Das Hin- und Her- sowie das Vor- und Zurückbewegen des Greifers ist mit erheblichem Zeitaufwand verbunden.

Die EP 0 480 066 A1 offenbart eine Vorrichtung, gemäß dem Oberbegriff des Patentanspruchs 1, zum Handhaben von zylindrischen Maskierungselementen, die mithilfe eines V-förmigen Anschlags auf einem Förderband zentriert werden, bevor die Maskierungselemente von einem Sauggreifer aufgenommen werden können.

Auch die EP 0 051 105 A3 offenbart einen V-förmigen Anschlag zum Zentrieren von zylindrischen Werkstücken.

Der Erfindung liegt die Aufgabe zugrunde, eine einfache Einrichtung zu schaffen, in der die Gurtspule schnell und sicher zentriert und auf eine defininierte Abholposition eingestellt werden kann.

Diese Aufgabe wird erfindungsgemäß durch die Einrichtung gemäß Anspruch 1 gelöst. Vorteilhafte Ausgestaltungen sind in den abhängigen Ansprüchen angegeben.

Es wird eine Einrichtung zum Zentrieren von elektrische Bauelemente aufnehmenden Gurtspulen für eine Anlage zum Lagern, Ein- und Ausgeben der Gurtspulen ange geben, wobei jeweils eine der Gurtspulen mit einer flachen Außenseite auf eine flache waagerechte Auflage der Einrichtung in einem Eingabebereich auflegbar ist. Die Einrichtung weist einen über bzw. oberhalb der Auflage angeordneten Anschlag für die lose aufgelegte Gurtspule auf, wobei der Anschlag zur Auflage senkrechte, sich zum Eingabebereich hin v-förmig öffnende Seitenwände aufweist, die Anschlagflächen für die Gurtspule bilden und wobei die Auflage relativ zu dem Anschlag derart verschiebbar ist, dass die Gurtspule zwischen die Seitenwände gelangt.

Durch die in der Art eines Trichters zueinander v-förmig angeordneten Seitenwände wird die Gurtspule aus dem Eingabebereich mit einer einfachen linearen Bewegung der Auflage sicher zwischen den Seitenwänden in eine zentrale Halteposition gebracht, in der die Gurtspule an beiden Seitenwänden anschlägt und in der sich die Spulenachse genau auf der Winkelhalbierenden der beiden Seitenwände befindet. Es ist dabei von Vorteil, wenn sich die Auflage in der Längsrichtung parallel zur Winkelhalbierenden bewegt. Mit der Bewegung der Auflage wird dann auch die auf der Auflage lose aufliegende Gurtspule in Richtung des Anschlags bzw. der durch den Anschlag gebildeten v-förmigen Seitenwände bewegt. Die Gurtspule wird durch die Wirkung der Seitenwände auf der Auflage z.B. auch in einer Richtung quer zur Bewegungsrichtung der Auflage verschoben. Durch eine hinreichend lange Verschiebebewegung wird auch eine im Eingabebereich seitlich von der Winkelhalbierenden aufgelegte Gurtspule sicher zentriert. In der Zentrierstellung liegt der Spulenrand der Gurtspule an wenigstens zwei Stellen an den Seitenwänden an.

Da die handelsüblichen Gurtspulen unterschiedliche Durchmesser aufweisen, sind die Seitenwände so bemessen, dass alle Spulengrößen sicher anschlagen können, wobei der mittlere Bereich zwischen den Seitenwänden in der Art eines Kegelstumpfes offen bleiben kann. Der Öffnungswinkel der beiden Seitenwände kann vorteilhaft 2-mal 45° betragen, um eine definierte Lagebeziehung zwischen der Gurtspule und dem Anschlag zu sichern.

Da die Gurtspule nur mit ihrem Eigengewicht lose auf der Auflage aufliegt, kommt es im Moment des Anschlagens zu einer Rutschbewegung zwischen der Gurtspule und der Auflage. Dadurch wird die höhere Haftreibung durch die niedrigere Gleitreibung abgelöst, bei der sich die Gurtspule leichter zentriert.

Die Auflage kann durch ein umlaufendes Transportband mit gebildet sein, wobei die Verschiebebewegung des Transportbands zumindest geringfügig über die Zentrierlage der Gurtspule hinaus fortsetzbar ist. Das Transportband kann eine Auflagefläche für die Gurtspule zur Verfügung stellen. Das kompakte Transportband kann beliebig lange Bewegungen in der Längsrichtung ausführen, ohne dass eine Rückbewegung erforderlich ist. Durch den Nachlauf des Transportbandes wird die Gurtspule sicher am Anschlag gehalten.

Der Anschlag kann in der Umlaufrichtung des Transportbands verschiebbar sein. Durch die Weiterbildung kann die Lage der Gurtspule auch nach dem Anschlagen bei weiter durchlaufendem Transportband entlang der Verschieberichtung des Anschlags verändert werden.

Die Verschiebepositionen des Anschlags können durch ein lineares, in der Längsrichtung wirkendes Positioniersystem bestimmbar sein. Das Positioniersystem ermöglicht damit den Antrieb des Anschlags unter genauer Kontrolle seiner Verschiebeposition.

Das Transportband und der Anschlag können in die gleiche Richtung bewegbar sein, wobei dabei die Umlaufgeschwindigkeit des Transportbandes höher sein kann als die Verschiebegeschwindigkeit des Anschlags. Die Bewegungen können dabei so abgestimmt sein, dass die Gurtspule auf den Anschlag in dessen Vorwärtsbewegung mit reduzierter Relativgeschwindigkeit trifft, worauf dieser in die vorberechnete Zentrierposition angebremst wird.

Ein optischer Sensor ist zur Erfassung Lage des Spulenrands der an den Seitenwänden anliegenden Gurtspule vorgesehen. Der stationäre Sensor kann senkrecht zur Auflagefläche auf die Mittelachse des Anschlags gerichtet sein. Durch den Sensor kann der Durchmesser der Gurtspule und damit die Lage der Spulenmitte bestimmt werden. Dies kann z. B. durch ein kontrolliertes Verschieben des Anschlags mit der Gurtspule erreicht werden bis der Spulenrand in den Abtastbereich des Sensors gelangt.

Die Gurtspule kann aus der optischen Abtastposition in eine definierte Übergabeposition der Spulenmitte verschiebbar sein. In der Übergabeposition kann die Gurtspule z.B. von einem Greifer einer Handhabungseinrichtung definiert entnommen und in einem Fach einer Lagereinrichtung abgelegt werden.

In der Übergabeposition kann ein versenkbarer und anhebbarer Fixierstift zum spielarmen Eingriff in die Spulennabe der Gurtspule vorgesehen sein. Der Fixierstift kann einen flanschartig verbreiterten Kragen zum Anheben der Gurtspule aufweisen. Das Transportband kann mittig längsgeteilt sein kann und den Bereich des Fixierstifts frei lassen. Die beiden Teile bzw. Bandelemente des Transportbands stellen eine funktionale Einheit dar. Nach dem Erreichen der Übergabeposition werden das Transportband und der Anschlag in einer Übergabeposition gestoppt, in der sich die Spulennabe genau über dem zylindrischen Fixierstift befindet. Beim Anheben des Fixierstifts greift dieser spielfrei in die Spulennabe ein. Der etwas tiefer gelegen Kragen des Fixierstifts legt sich an die Spulenunterseite an und kann diese soweit anheben, dass der großflächige schieberartige Greifer unter die Gurtspule gelangen kann.

Durch Absenken des Fixierstifts kommt dann die Gurtspule auf dem Schieber zur Auflage. Nach dem Anheben der Gurtspule kann eine weitere Gurtspule z.B. von einem auf dieser Seite angeordneten Bandtransport in den Eingabebereich eingeführt werden, ohne dass dadurch die angehobene Gurtspule beeinflusst wird.

Der Anschlag kann über das Höhenniveau der Gurtspule anhebbar sein. Damit kann der Anschlag kollisionsfrei über der Gurtspule in seine Zentrierposition zurückgeschoben und abgesenkt werden. Sobald der zurückgefahrene Anschlag seine Zentrierposition erreicht hat, kann ein neuer Zentriervorgang kann in Gang gesetzt werden.

Die Zentriereinrichtung kann in einem Gurtspulenlager überall dort zum Einsatz kommen, wo die Gurtspule aus einer undefinierten Lage z.B. auf einem Eingabeband in eine definierte Übergabeposition gebracht werden muss. Insbesondere ist es von Vorteil, wenn der Übergabeposition soweit von der Zentrierposition entfernt ist, dass eine neue Gurtspule in den Eingabebereich eingeführt und zentriert werden kann, bevor die vorherige Gurtspule die Zentriereinrichtung verlassen hat.

Im Folgenden wird die Erfindung anhand eines in der Zeichnung dargestellten Ausführungsbeispieles näher erläutert. Es zeigen:
- Figur 1: eine schematisierte Seitansicht einer Zentriereinrichtung für Gurtspulen,
- Figur 2: eine Draufsicht auf die Zentriereinrichtung nach Figur 1.

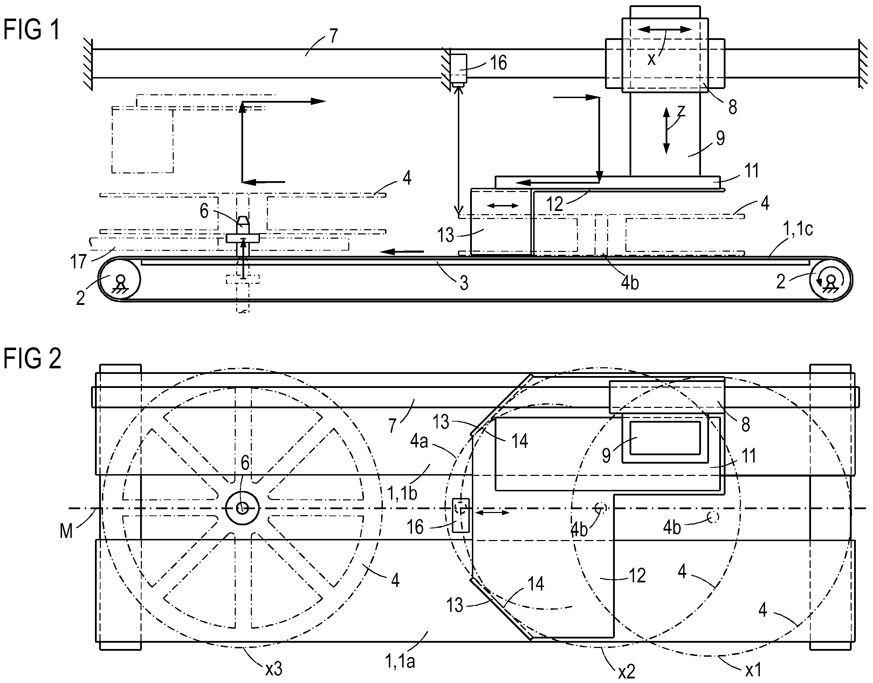

Die Figuren 1 und 2 zeigen im Wesentlichen die Funktionselemente einer Einrichtung zum Zentrieren von elektrische Bauelemente aufnehmenden Gurtspulen. Stationäre Rahmenteile sind der besseren Erkennbarkeit der Funktionselemente und Abläufe halber weggelassen. Die Bewegungspfeile z.B. x, z deuten die Bewegungen der Funktionselemente an.

Die Einrichtung weist einen stationären Bandtransport mit einem umlaufenden Transportband 1 auf, das zwischen zwei Umlenkrollen 2 gespannt ist, von denen eine als schaltbare Antriebsrolle dient. Der obere Teil des Transportbands 1 liegt auf einer stationären waagerechten ebenen Gleitplatte 3 auf und bildet auf seiner Oberseite eine waagerechte Auflagefläche 1c für flache Außenseiten von Gurtspulen 4. Das mittig längs geteilte Transportband 1 weist zwei Bandelemente 1a, 1b auf und lässt dazwischen einen Mittelstreifen für einen Fixierstift 6 frei, der aus einer unter das Bandniveau versenkten Lage über die Bandoberseite bzw. Auflagefläche 1c herausgehoben werden kann.

Oberhalb des Bandtransports erstreckt sich parallel zur Umlaufrichtung des Transportbands 1 in einer Längsrichtung x eine stationäre lineare Führungsschiene 7, an der ein Führungsschlitten 8 spielfrei geführt und z.B. durch einen nicht dargestellten Zahnriemen verschiebbar ist. Ein nicht dargestellter Antriebsmotor für den Zahnriemen, der Zahnriemen selbst, die Führungsschiene und der Führungsschlitten bilden ein lineares Positioniersystem, bei dem es ein z.B. am Motor angebrachter Encoder ermöglicht, die Verschiebeposition des Führungsschlittens kontinuierlich zu kontrollieren. Der Führungsschlitten 8 weist seinerseits eine senkrechte Linearführung für einen Führungszapfen 9 auf, der durch einen nicht dargestellten Hubantrieb in einer senkrechten Hubrichtung z verschiebbar ist.

An der Unterseite des Führungszapfens 9 ist eine formsteife Verbindungsplatte 11 befestigt, anderen Unterseite ein zum Transportband 1 paralleles Zentrierblech 12 angebracht ist. Von diesem sind zwei zueinander schräge Zentrierlappen 13 rechtwinkelig zum Transportband 1 hin derart abgebogen, dass sie senkrecht zur Oberseite des Transportbandes 1 stehen. Die Höhe der Zentrierlappen 13 ist größer als die größte zu erwartende Dicke eines der Gurtspulentypen. Das Zentrierblech 12 stellt den eigentlichen Anschlag für die Gurtspule 4 dar. Die einander zugewandten inneren Seitenwände 14 der Zentrierlappen 13 bilden in der Draufsicht (Fig. 2) auf die Bandebene zueinander einen rechten Winkel, dessen winkelhalbierende Mittelachse M parallel zur Längsrichtung x verläuft und sich annähernd mit der Bandmitte deckt. Die Seitenwände 14 dienen als Anschlagflächen für die sich zentrierende Gurtspule 4. Über der Mittelachse M ist die Zentriereinrichtung mit einem stationären optischen Sensor 16 in der Nähe der fiktiven Ecke zwischen den Seitenwänden 14 versehen, der auf den reflektierenden Rand einer anschlagenden Gurtspule 4 gerichtet ist.

Die in Figur 2 dargestellten strichpunktierten Vollkreise symbolisieren die äußereren Ränder einer Gurtspule 4 in verschiedenen Phasen des Zentrierens. Dabei zeigen die Bezugszeichen x1 die Eingabeposition der Gurtspule 4 in einem Eingangsbereich des Bandtransports, x2 eine Zentrierposition und x3 eine Übergabeposition, die der Lage des Fixierstifts 6 entspricht. Die Innenseiten der Seitenwände 14 öffnen sich trichterartig v-förmig zu der in der Position x1 befindlichen Gurtspule 4, die z.B. seitlich versetzt auf dem ruhenden Transportband 1 aufliegt. Das Zentrierblech 12 befindet sich mit geringem Abstand über einem Mittelabschnitt des Transportbands 1 in einer Zentrierstellung für die Gurtspule 4 in der Position x2. Die Übergabeposition x3 befindet sich am dem Eingabebereich gegenüberliegenden Ende des Transportbands 1.

Die Gurtspule 4 kann z.B. mittels eines Querschiebers von einer Längsseite des Transportbands 1 her oder stirnseitig von einem angrenzenden anderen Bandtransport in den Eingabebereich eingebracht worden sein. Das Transportband 1 fährt die aufliegende Gurtspule 4 in die Richtung der Zentrierlappen 13, die im abgesenkten Zustand knapp über der Bandoberseite enden. Beim Anschlagen an diese zentriert die Gurtspule 4 sich mittig zwischen den beiden Zentrierlappen 13. Das Transportband 1 bleibt dabei weiter im Umlauf. Das Zentrierblech 12 wird dann in der Längsrichtung soweit und sooft ausgelenkt bis der Spulenrand vor dem Sensor 16 erfasst wird. Dabei lässt sich aus der Verschiebeposition der Zentrierlappen 13 die Mittelachse bzw. der Mittelpunkt 4b der anschlagenden Gurtspule 4 errechnen, der der Zentrierposition x2 entspricht. Der dargestellte Teilkreis 4a deutet die Umrisse einer kleineren Gurtspule an, die in der Längsrichtung x etwas weiter zwischen den Zentrierlappen 13 hervorragt und eine abweichende Zentrierposition des Zentrierblechs 12 ergibt.

Bei weiter umlaufendem Transportband 1 verfährt das Zentrierblech 12 mit etwas reduzierter Geschwindigkeit zur Übergabeposition x3, wobei die Gurtspule 4 stets im Anschlag bleibt. Die hohle Spulennabe befindet sich nun deckungsgleich über dem im Bandtransport versenkten Fixierstift 6. Das Transportband 1 wird gestoppt, das Zentrierblech 12 mit den Zentrierlappen 13 über das Spulenniveau angehoben und der Fixierstift 6 nach oben geschoben. Er taucht dabei spielfrei in die Spulennabe ein. Ein verbreiteter Kragen des Fixierstifts 6 legt sich an die Spulenunterseite an und hebt diese so hoch, dass ein schieberartiger flacher Greifer 17 von der Stirnseite des Bandtransports her darunter geschoben werden kann. Nach dem Absenken des Fixierstifts 6 liegt die Gurtspule 4 auf dem Greifer 17 auf und wird durch diesen aus der Zentriereinrichtung entnommen.

Unmittelbar nach dem Abheben der Gurtspule 4 vom Transportband kann bereits eine weitere Gurtspule in die Eingabeposition gebracht werden. Das angehobene Zentrierblech 12 wird unverzüglich in die Zentrierposition zurückgeschoben und knapp über das Transportband 1 abgesenkt. Noch während sich die Gurtspule 4 über dem Transportband 1 befindet, kann bereits ein neuer Zentriervorgang mit der neuen Gurtspule gestartet werden.

### Bezugszeichen

- x: Längsrichtung
- z: Hubrichtung
- M: Mittelachse
- 1: Transportband
- 1a: Bandelement
- 1b: Bandelement
- 1c: Auflagefläche
- 2: Umlenkrolle
- 3: Gleitplatte
- 4: Gurtspule
- 4a: Teilkreis
- 4b: Mittelpunkt
- 6: Fixierstift
- 7: Führungsschiene
- 8: Führungsschlitten
- 9: Führungszapfen
- 11: Verbindungsplatte
- 12: Zentrierblech
- 13: Zentrierlappen
- 14: Seitenwand
- 16: Sensor
- 17: Greifer

## Patentansprüche

1. Einrichtung zum Zentrieren von elektrische Bauelemente aufnehmenden Gurtspulen (4) unterschiedlichen Außendurchmessers für eine Anlage zum Lagern, Ein- und Ausgeben der Gurtspulen (4), wobei jeweils eine der Gurtspulen (4) mit einer flachen Außenseite auf eine flache waagerechte Auflage (1c) der Einrichtung in einem Eingabebereich auflegbar ist, wobei
- die Einrichtung einen über der Auflage (1c) angeordneten Anschlag (12) für die lose aufgelegte Gurtspule (4) aufweist,
- der Anschlag (12) zur Auflage (1c) senkrechte, sich zum Eingabebereich hin v-förmig öffnende Seitenwände (14) aufweist, die Anschlagflächen für die Gurtspule (4) bilden, und
- die Auflage (1c) relativ zu dem Anschlag (12) derart verschiebbar ist, dass die Gurtspule (4) zwischen die Seitenwände (14) gelangt,
**dadurch gekennzeichnet, dass**
- ein optischer Sensor (16) zur Erfassung der Lage des Spulenrands der an den Seitenwänden (14) anliegenden Gurtspule (4) vorgesehen ist.

2. Einrichtung nach Anspruch 1, **dadurch gekennzeichnet, dass**
- die Auflage ein umlaufendes Transportband (1) mit einer Auflagefläche (1c) aufweist, und dass
- die Verschiebebewegung des Transportbands (1) zumindest geringfügig über eine Zentrierlage der Gurtspule (4) hinaus fortsetzbar ist.

3. Einrichtung nach Anspruch 1 oder 2, **dadurch gekennzeichnet, dass** der Anschlag (12) in der Umlaufrichtung des Transportbands (1) verschiebbar ist.

4. Einrichtung nach Anspruch 3, **dadurch gekennzeichnet, dass** Verschiebepositionen des Anschlags (12) durch ein lineares, in der Längsrichtung (x) wirkendes Positioniersystem bestimmbar sind.

5. Einrichtung nach Anspruch 2, 3 oder 4, **dadurch gekennzeichnet, dass**
- das Transportband (1) und der Anschlag (12) in die gleiche Richtung bewegbar sind, und dass
- dabei die Umlaufgeschwindigkeit des Transportbandes (1) höher ist als die Verschiebegeschwindigkeit des Anschlags (12).

6. Einrichtung nach Anspruch einem der vorhergehenden Ansprüche, **dadurch gekennzeichnet, dass**
der Sensor (16) senkrecht zu der Auflagefläche (1c) auf die Mittelachse des Anschlags (12) gerichtet ist.

7. Einrichtung nach einem der vorhergehenden Ansprüche, **dadurch gekennzeichnet, dass** die Gurtspule (4) aus der optischen Abtastposition in eine definierte Übergabeposition der Spulenmitte verschiebbar ist.

8. Einrichtung nach Anspruch 7, **dadurch gekennzeichnet, dass**
- in der Übergabeposition (x3) ein versenkbarer und anhebbarer Fixierstift (6) zum Eingriff in die Spulennabe der Gurtspule (4) vorgesehen ist,
- der Fixierstift (6) einen flanschartig verbreiterten Kragen zum Anheben der Gurtspule (4) aufweist, und dass

9. Einrichtung nach einem der vorhergehenden Ansprüche, **dadurch gekennzeichnet, dass**
- das Transportband (1) mittig in zwei Bandelemente (1a, 1b) längsgeteilt ist, und dass
- zwischen den beiden Bandelementen (1a, 1b) ein Bereich für einen Fixierstift (6) frei gehalten ist.

10. Einrichtung nach einem der vorhergehenden Ansprüche, **dadurch gekennzeichnet, dass** der Anschlag (12) über das Höhenniveau der Gurtspule (4) anhebbar ist.

## Claims

1. Device for centring belt reels (4) accommodating an electrical component, of differing diameters, for an installation for the storage, inputting, and outputting of belt reels (4), wherein in each case one of the belt reels (4) can be laid with a flat outer side on a flat horizontal contact surface (1c) of the device in an input region, wherein
- the device comprises a stop element (12) arranged above the contact surface (1c) for the loosely placed belt reel (4),
- the stop element (12) comprises perpendicular side walls (14) open in a V-shape towards the input region, which form the contact surfaces for the belt reel (4), and
- the contact surface (1c) can be displaced relative to the stop element (12) in such a way that the belt reel (4) passes between the side walls (14),
**characterized in that**
- an optical sensor (16) is provided for detecting the location of the reel edge of the belt reel (4) which is in contact with the side walls (4).

2. Device according to claim 1, **characterized in that**
- the contact surface comprises a circulating transport band (1) with a contact surface (1c), and that
- the displacement movement of the transport band (1) can be continued at least slightly over a centring position of the belt reel (4).

3. Device according to claim 1 or 2, **characterized in that**
- the stop element (12) can be displaced in the circumferential direction of the transport belt (1).

4. Device according to claim 3, **characterized in that**
- displacement positions of the stop element (12) can be determined by a linear positioning system which takes effect in the longitudinal direction (x).

5. Device according to claim 2, 3 or 4, **characterized in that**
- the transport band (1) and the stop element (12) can be moved in the same direction, and that
- in this situation the circumferential speed of the transport belt (1) is higher than the displacement speed of the stop element (12).

6. Device according to any one of the preceding claims, **characterized in that**
- the sensor (16) is aligned perpendicular to the contact surface (1c) onto the middle axis of the stop element (12).

7. Device according to any one of the preceding claims, **characterized in that**
- the belt reel (4) can be displaced out of the optical scanning position into a defined transfer position of the middle of the coil.

8. Device according to claim 7, **characterized in that**
- in the transfer position (x3), a fixing pin (6) is provided, which can be lowered and raised in order to engage into the reel hub of the belt reel (4),
- the fixing pin (6) comprises a flange-type broadened collar for raising the belt reel (4).

9. Device according to any one of the preceding claims, **characterized in that**
- the transport band (1) is divided longitudinally into two band elements (1a, 1b), and that
- a region for a fixing pin (6) is kept free between the two band elements (1a, 1b).

10. Device according to any one of the preceding claims, **characterized in that**
- the stop element (12) can be raised above the height level of the belt reel (4).

## Revendications

1. Dispositif pour centrer des bobines de ceinture (4), logeant des composants électriques, présentant des diamètres extérieurs différents pour une installation pour stocker, faire entrer et sortir les bobines de ceinture (4), dans lequel respectivement une des bobines de ceinture (4) peut être posée dans une zone d'entrée sur un support (1c) horizontal plat du dispositif par un côté extérieur plat, dans lequel
- le dispositif présente une butée (12) disposée au-dessus du support (1c) pour la bobine de ceinture (4) posée de manière lâche,
- la butée (12) présente des parois latérales (14) perpendiculaires par rapport au support (1c), s'ouvrant en forme de V en direction de la zone d'entrée, qui forment des faces de butée pour la bobine de ceinture (4), et
- le support (1c) peut être déplacé de telle manière par rapport à la butée (12) que la bobine de ceinture (4) parvient entre les parois latérales (14), **caractérisé en ce que**
- un capteur optique (16) est prévu pour détecter la position du bord de bobine de la bobine de ceinture (4) reposant sur les parois latérales (14).

2. Dispositif selon la revendication 1, **caractérisé en ce que**
- le support présente une bande de transport (1) continue avec une face de support (1c),
et que
- le mouvement de déplacement de la bande de transport (1) peut se poursuivre au moins légèrement au-delà d'une position de centrale de la bobine de ceinture (4) .

3. Dispositif selon la revendication 1 ou 2, **caractérisé en ce que**
la butée (12) peut être déplacée dans le sens de rotation de la bande de transport (1).

4. Dispositif selon la revendication 3, **caractérisé en ce que**
des positions de déplacement de la butée (12) peuvent être définies par un système de positionnement linéaire agissant dans la direction longitudinale (x).

5. Dispositif selon la revendication 2, 3 ou 4, **caractérisé en ce que**
- la bande de transport (1) et la butée (12) peuvent être déplacées dans la même direction,
et que
- ce faisant la vitesse de déplacement continue de la bande de transport (1) est plus élevée que la vitesse de déplacement de la butée (12).

6. Dispositif selon l'une des revendications précédentes, **caractérisé en ce que**
le capteur (16) est dirigé perpendiculairement par rapport à la face de support (1c) sur l'axe central de la butée (12).

7. Dispositif selon l'une des revendications précédentes, **caractérisé en ce que** la bobine de ceinture (4) peut être déplacée depuis la position de balayage optique dans une position de transfert définie du centre de bobine.

8. Dispositif selon la revendication 7, **caractérisé en ce que**
- une tige de blocage (6) pouvant être abaissée et soulevée est prévue pour venir en prise avec le moyeu de bobine de la bobine de ceinture (4) dans la position de transfert (x3),
- la tige de blocage (6) présente un rebord élargi à la manière d'une bride pour soulever la bobine de ceinture (4).

9. Dispositif selon l'une des revendications précédentes, **caractérisé en ce que**
- la bande de transport (1) est divisée longitudinalement au centre en deux éléments de bande (1a, 1b), et que
- une zone pour une tige de blocage (6) est maintenue libre entre les deux éléments de bande (1a, 1b).

10. Dispositif selon l'une des revendications précédentes, **caractérisé en ce que** la butée (12) peut être soulevée au-dessus du niveau de hauteur de la bobine de ceinture (4).
